Europäisches Patentamt

European Patent Office

Office européen des brevets

(19)

(11) Veröffentlichungsnummer: **0 048 380**
**A1**

## (12) EUROPÄISCHE PATENTANMELDUNG

(21) Anmeldenummer: 81107036.6

(22) Anmeldetag: 07.09.81

(51) Int. Cl.³: **H 01 J 9/14**
**C 23 F 1/02, C 25 D 5/02**

(30) Priorität: 23.09.80 DE 3035859
18.08.81 DE 3132658

(43) Veröffentlichungstag der Anmeldung:
31.03.82 Patentblatt 82/13

(84) Benannte Vertragsstaaten:
AT CH FR GB IT LI NL SE

(71) Anmelder: SIEMENS AKTIENGESELLSCHAFT Berlin
und München
Postfach 22 02 61
D-8000 München 22(DE)

(72) Erfinder: Trausch, Günther, Dipl.-Ing.
Feldafinger Strasse 39 b
D-8000 München 71(DE)

(72) Erfinder: Houben, Wilfried, Ing. grad.
Anette-Kolb-Anger 15
D-8000 München 83(DE)

(54) Verfahren zur ätztechnischen und/oder galvanischen Herstellung von Ringzonen in engen Bohrungen.

(57) Um die Metallisierung an den Bohrungsinnenwänden in Werkstücken auf einer im Verhältnis zur Bohrungstiefe kurzen Distanz zu unterbrechen oder um schmale leitende Ringzonen auf der Mantelfläche von Bohrungen zu erzeugen, werden die Bohrungen mit einem Positiv-Fotolack angefüllt, der sich bildende Lackstöpsel mit UV-Licht bestrahlt, das Werkstück in Lackentwickler getaucht, um die Bohrungswände bis auf einen Ring von Lack zu befreien und entweder bei der Herstellung isolierender Ringzonen die vom Lack befreiten Bereiche metallisiert, der Fotolack abgelöst und die freiliegende Grundmetallisierung selektiv abgeätzt, so daß das Werkstoffmaterial an der Ringzone freiliegt oder zur Herstellung leitender Ringzonen die Grundmetallisierung in den vom Fotolack befreiten Bereichen ätztechnisch abgelöst.

./...

EP 0 048 380 A1

SIEMENS AKTIENGESELLSCHAFT
Berlin und München

Unser Zeichen
VPA 80 P 7 1 3 9 E

Verfahren zur ätztechnischen und/oder galvanischen Herstellung von Ringzonen in engen Bohrungen.

Die Erfindung betrifft ein Verfahren zur ätztechnischen und/oder galvanischen Herstellung von elektrisch leitenden oder isolierenden Ringzonen in der Mantelfläche von engen, durchgehenden Bohrungen in Werkstücken geringer Dicke.

Zum Beispiel wird beim flachen Plasmabildschirm nach der DE-AS 24 12 869 für jeden Bildpunkt der Elektronenstrom aus dem Plasmaraum zum Leuchtstoff des Bildschirmes durch eine Elektrodenmatrix, die auf der sogenannten Steuerscheibe aufgebracht ist, reguliert. Die Steuerscheibe hat etwa die Größe des Bildschirmes und besteht aus Glas, das mit Durchgangsbohrungen im Raster der Bildpunkte versehen und beidseitig mit metallischen Leiterbahnen belegt ist. Wenn aus Gründen der Wandaufladung die Bohrungsinnenwände metallisiert sein müssen, dann muß die Metallisierung jedoch bezogen auf die Höhe der Bohrung etwa in der Bohrungsmitte auf eine kurze Distanz unterbrochen sein, so daß die zwei Seiten der Steuerscheibe an keiner Stelle elektrisch leitend verbunden sind. Wegen der Feinheit und Vielzahl der Bohrungen ist die Herstellung dieser isolierenden Ringzone schwierig.

Der Erfindung liegt die Aufgabe zugrunde, ein Verfahren anzugeben, mit dem - wie eingangs beschrieben - in engen Bohrungen entweder isolierende oder leitende Ringzonen erzeugt werden können. Diese Aufgabe wird dadurch gelöst, daß auf der Werkstückoberfläche einschließlich der Bohrungswände in an sich bekannter Weise eine Grundmetallisierung aufgebracht wird, anschließend die

Wed 1 Plr/19.9.1980

Bohrungen mit einem Positiv-Fotolack angefüllt werden, der sich beim Trocknen von den Öffnungen nach innen wegzieht und einen Stöpsel bildet, daß ferner durch beidseitiges Bestrahlen mit UV-Licht der Fotolack partiell für einen Lackentwickler, der in die Bohrungen eindringt, löslich gemacht und bis auf einen gewünschten Lackring herausgelöst wird, daß danach entweder zur Herstellung isolierender Ringzonen auf den vom Fotolack befreiten Bereichen durch galvanische Abscheidung eine oder mehrere Metallschichten aufgebracht werden, der restliche Fotolack abgelöst und die Grundmetallisierung selektiv abgeätzt wird, oder zur Herstellung leitender Ringzonen die Grundmetallisierung in den vom Fotolack befreiten Bereichen ätztechnisch abgelöst wird. Auf diese Weise ist es möglich, auch in einer Vielzahl sehr dicht beieinanderliegender feiner Bohrungen extrem schmale Ringzonen, die alle in einer Ebene parallel zur Werkstückoberfläche liegen, zu erzeugen.

Nach einer Weiterbildung des erfindungsgemäßen Verfahrens wird das Werkstück in Abhängigkeit von seiner Dicke und der Bohrungsgeometrie unter einem bestimmten Winkel zur Lackoberfläche geneigt in den Fotolack eingetaucht. Auf diese Weise werden Lufteinschlüsse in den Bohrungen vermieden.

Nach einer Weiterbildung der Erfindung wird die Ringbreite durch die Bestrahlungszeit festgelegt.

Nach einer weiteren Variante der Erfindung wird vor dem Eintauchen des Werkstückes in den Entwickler die Luft aus den Bohrungen teilweise evakuiert, damit der Entwickler in die Bohrungen eindringen kann.

Nach einer Weiterbildung der Erfindung erfolgt die Steuerung der Ringbreite unabhängig von der Bestrahlungszeit dadurch, daß die Eindringtiefe des Lackentwicklers über den Grad der Luftevakuierung festgelegt wird. Mit
dieser Methode können auf einfache Weise verhältnismäßig
breite Ringzonen erzeugt werden.

Nach einer Weiterbildung der Erfindung werden die Bohrungen mit einer leichten Verengung hergestellt, so daß sich
der Lackstöpsel an dieser Stelle ausbildet und somit die
Lage der Lackringe festgelegt wird.

Liegen die Lackstöpsel bezogen auf die Höhe der Bohrung
nicht mittig, so erfolgt nach der Erfindung die Belichtung von beiden Seiten verschieden lang.

Eine weitere Variante der Erfindung besteht darin, daß
das Werkstück nach der gleichen Belackung, wobei aber bei
dieser Ausführung auch andere Lacke verwendet werden
können, ohne vorherige UV-Bestrahlung bei definiertem
Unterdruck in ein den Lack lösendes Entschichtungsmedium
getaucht wird, nach dem Druckausgleich für eine bestimmte
Verweilzeit darin  bleibt und anschließend durch Abspülen
der Entschichtungsvorgang gestoppt wird. Das in den
Bohrungen eingeschlossene Luftvolumen hängt direkt vom
Grad der Evakuierung vor dem Tauchen ab. Da die Flüssigkeit in geringem Maße auch an den Bohrungswänden im Lack
weiterkriecht, unter Umgehung des Luftvolumens, ist neben
der Evakuierung auch die Expositionszeit im Entschichter
für die verbleibende Lackringbreite maßgebend.

Nach einer Weiterbildung der Erfindung wird die verbleibende Lackringbreite durch die Größe des Unterdruckes
vor dem Tauchen des Werkstückes in das Entschichtungsmedium gesteuert.

Nach einer weiteren Ausbildung der Erfindung werden vor
der Abscheidung einer oder mehrerer Metallschichten bzw.
bei der Herstellung einer leitenden Ringzone vor dem Abätzen der Grundmetallisierung die Werkstoffoberflächen ein- oder beidseitig fotolithografisch mit einem Negativtrockenresist strukturiert, dessen Entwickler den Positivlackring in den Bohrungen nicht beschädigt. Dadurch wird es ermöglicht, die erwähnten Ringzonen auch in Werkstücken mit strukturierter Oberfläche zu erzeugen.

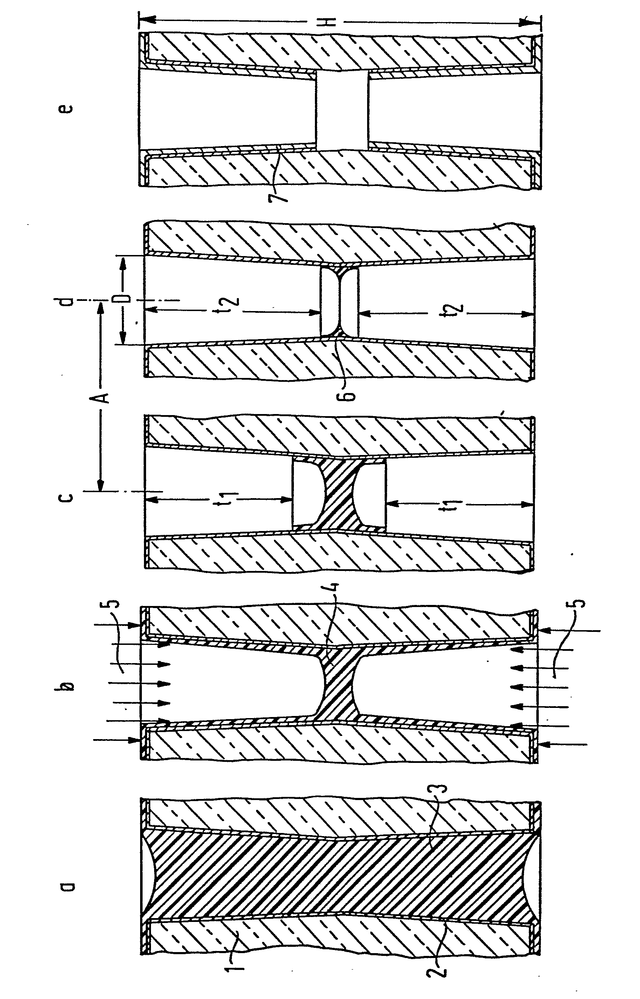

Die Erfindung wird anhand der Figur erläutert, in der in den Skizzen a) bis e) die einzelnen Verfahrensschritte an einem Loch mit leichter Verengung dargestellt sind.

In dem Werkstück 1, das z. B. aus 1 mm starkem Glas  H besteht, sind eine Vielzahl durchgehender Bohrungen, z. B. mit einem Durchmesser D von 0,2 mm in einem Rasterabstand A von z. B. 0,4 mm angeordnet. Diese Bohrungen werden bekannterweise durch zweiseitiges Ätzen in das Werkstück 1 eingebracht und können im Querschnitt rund, oval oder eckig sein. Die gesamte Werkstückoberfläche einschließlich der Bohrungswände ist mit einer dünnen Metallschicht 2 überzogen.

Zur Herstellung einer leitenden oder isolierenden Ringzone in den Bohrungen werden die Bohrungen mit einem Positiv-Fotolack 3 (Skizze a) in der Weise angefüllt, daß der Lack nur von einer Seite eintritt und die in der Bohrung enthaltende Luft verdrängt. Durch Kapillarwirkung füllen sich Bohrungen der dargestellten Größenordnung beim Kontakt mit Fotolack an einer Öffnung mit diesem und halten ihn fest. Praktisch realisiert man die Lackeinbringung durch schräges Eintauchen des Werkstückes in den Lack und senkrechtes Herausziehen mit definierter Geschwindigkeit.

Beim Trocknen des Lackes bildet sein Feststoff eine dünne Schicht an der Werkstückoberfläche. In den Bohrungen zieht sich seine Oberfläche von den Öffnungen weg nach innen zurück. Aufgrund der Oberflächenspannung des Lackes sammelt sich schließlich der Lackfeststoff exakt um die engste Bohrungsstelle als ein den Bohrungsquerschnitt
ausfüllender Stöpsel 4 (Skizze b). Die Dicke des Stöpsels
ist vom Volumen der Bohrung, dem Durchmesser, ihrer Wandneigung und vom Feststoffgehalt des Lackes abhängig.

Durch beidseitiges Bestrahlen des Werkstückes mit
UV-Licht 5 werden die relativ dünne Lackschicht an der
Werkstückoberseite sowie auf den Bohrungswänden und ein
Teil des Stöpsels chemisch so verändert, daß sie in einem
Lackentwickler löslich sind. Damit der meist wäßrige Entwickler in die nunmehr als Sacklöcher zu betrachtenden
Bohrungen eindringt, ist es von Vorteil, die enthaltene
Luft teilweise zu evakuieren, das heißt, das Werkstück
bei vermindertem Umgebungsdruck in den Lackentwickler
einzutauchen.

Wenn die Evakuierung unvollständig ist, wird nach dem Ausgleich des Unterdruckes bei noch getauchtem Werkstück der
Entwickler soweit in die Bohrungen gedrückt, wie es die
verbleibende Luft gestattet. Da das Verhältnis Volumen der
Bohrung zum Volumen der eingeschlossenen Luft für jede
Bohrung gleich und nur durch das gewählte Vakuum bestimmt
wird, kann bei konstanter Neigung der Bohrungswände auf
diese Weise vorgegeben werden, bis zu welcher Tiefe t der
Entwickler eintritt, das heißt, wie weit die Bohrungswand vom Lack befreit wird. In der Skizze c ist die Eindringtiefe mit t1 bezeichnet. Diese Methode ist nicht
anwendbar, wenn das eingeschlossene Luftvolumen so klein
ist, daß der Entwickler bereits die Ränder des Stöpsels
berührt.

Soll der mit Lack geschützte Ringbereich in der Bohrung
schmäler sein, als es mit der beschriebenen Methode erreicht werden kann, oder ist wegen nachfolgender Naßprozesse eine durchgehende Bohrung erforderlich, so wird
wie folgt verfahren:

- 6 -    VPA 80 P 7139  E

Die beidseitige UV-Bestrahlung ist so zu wählen, daß der Stöpsel im Bereich der Bohrungsachse in voller Dicke, nicht aber in Wandnähe, im Entwickler löslich wird. Das ist leicht realisierbar, weil einerseits der Stöpsel mittig am dünnsten und andererseits die Lichtintensität hier am höchsten ist. Durch Evakuieren der Luft in der Umgebung des Werkstückes bis annähernd zum Erreichen des Entwicklerdampfdruckes, ferner durch Eintauchen des Werkstückes und anschließenden Ausgleich des Unterdruckes kann der Stöpsel bis auf einen Ring 6 an der Bohrungswand herausgelöst werden (Skizze d). Die Breite des Lackringes ist über die Dauer der UV-Bestrahlung steuerbar. In der Skizze d ist mit t2 die Höhe der vom Lack befreiten Bohrungswand bezeichnet.

Liegt axial gesehen der Lackstöpsel nicht in Bohrungsmitte, so können von jeder Seite unterschiedliche Bestrahlungszeiten erforderlich sein. Ist der Bohrungsquerschnitt nicht kreisförmig, so kann aufgrund unterschiedlicher Stöpselstärke in Wandnähe und/oder Abschattung des UV-Lichtes der entstehende Lackring ungleichmäßig breit sein. Diese Erscheinung läßt sich durch konstante oder kontinuierlich veränderte Neigung des Werkstückes gegen die Lichtrichtung beim Bestrahlen weitgehend aufheben.

In dem in der Skizze b) dargestellten Verfahrensstadium wird für die Variante nach den Patentansprüchen 9 und 10 der Erfindung das Werkstück bei definiertem Unterdruck in ein den Lack lösendes Entschichtungsmedium eingetaucht. Nach Ausgleich des Unterdruckes auf Umgebungsdruck dringt die Flüssigkeit soweit in die Bohrungen ein, bis sie von dem verbliebenen Luftvolumen gestoppt wird und löst hier von den Bohrungswänden den Lack ab. An der Werkstückoberfläche wird der Lack ebenfalls entfernt.

Da das Verhältnis Volumen der Bohrung zum Volumen der eingeschlossenen Luft für jede Bohrung gleich und nur durch das gewählte Vakuum bestimmt wird, kann bei konstanter Neigung der Bohrungswände auf diese Weise vorgegeben werden, bis zu welcher Tiefe t das Entschichtungsmedium eintritt, das heißt, wie weit die Bohrungswand vom Lack befreit wird. In der Skizze c ist die Eindringtiefe mit t1 bezeichnet. Diese Methode ist nicht anwendbar, wenn das eingeschlossene Luftvolumen so klein ist, daß das Entschichtungsmedium bereits die Ränder des Stöpsels 4 berührt.

Durch Spülen des Werkstückes, z. B. mit Wasser, wird das Entschichtungsmedium verdünnt und verdrängt. Dadurch ist der Lackentschichtungsvorgang beendet.

An die Fotolackabdeckung schließt sich bei den beschriebenen Methoden, wenn es um die Herstellung isolierender Ringzonen geht, die galvanische Abscheidung einer oder mehrerer Metallschichten 7 (Skizze e) auf den vom Fotolack befreiten Bereichen an. Zum Schluß wird der Fotolack-Ring abgelöst und die nun freiliegende Grundmetallisierung selektiv abgeätzt, so daß hier der Werkstückgrundstoff 1 freiliegt.

Bei der Herstellung leitender Ringzonen wird hingegen nach dem Herauslösen des Fotolacks mit seinem Entwickler die Grundmetallisierung in den vom Fotolack befreiten Bereichen ätztechnisch abgelöst.

Falls notwendig kann vor der Abscheidung einer oder mehrerer Metallschichten bzw. bei der Herstellung einer leitenden Ringzone vor dem Ätzen der Grundmetallisierung die Werkstückoberfläche ein- oder beidseitig fotolithografisch mit einem Negativtrockenresist strukturiert werden, dessen Entwickler den Positivlackring in den Bohrungen nicht beschädigt.

10 Patentansprüche
1 Figur

<u>Patentansprüche.</u>

1. Verfahren zur ätztechnischen und/oder galvanischen Herstellung von elektrisch leitenden oder isolierenden Ringzonen in der Mantelfläche von engen, durchgehenden Bohrungen in Werkstücken geringer Dicke, vorzugsweise von 0,1 bis 3 mm, d a d u r c h   g e k e n n z e i c h - n e t ,   daß auf der Werkstückoberfläche (1) einschließlich der Bohrungswände in an sich bekannter Weise eine Grundmetallisierung (2) aufgebracht wird, anschließend die Bohrungen mit einem Positiv-Fotolack (3) angefüllt werden, der sich beim Trocknen von den Öffnungen nach innen wegzieht und einen Stöpsel (4) bildet, daß ferner durch beidseitiges Bestrahlen mit UV-Licht (5) der Fotolack partiell für Lackentwickler löslich gemacht und bis auf einen gewünschten Lackring (6) herausgelöst wird, daß danach entweder zur Herstellung isolierender Ringzonen auf den vom Fotolack befreiten Bereichen durch galvanische Abscheidung eine oder mehrere Metallschichten (7) aufgebracht werden, der restliche Fotolack abgelöst und die Grundmetallisierung selektiv abgeätzt wird, oder zur Herstellung leitender Ringzonen, die Grundmetallisierung in den vom Fotolack befreiten Bereichen ätztechnisch abge- löst wird.

2. Verfahren nach Anspruch 1, d a d u r c h   g e - k e n n z e i c h n e t ,   daß das Werkstück in Abhängigkeit von seiner Dicke und der Bohrungsgeometrie unter einem bestimmten Winkel zur Lackoberfläche geneigt in den Fotolack eingetaucht wird.

3. Verfahren nach Anspruch 1 und 2, d a d u r c h   g e k e n n z e i c h n e t ,   daß die Steuerung der Ringbreite in Abhängigkeit von der Bestrahlungszeit festgelegt wird.

4. Verfahren nach den Ansprüchen 1, 2 und 3, d a - durch gekennzeichnet , daß vor dem
Eintauchen des Werkstückes in den Entwickler die Luft
aus den Bohrungen teilweise evakuiert wird.

5. Verfahren nach den Ansprüchen 1, 2 und 4, da -
durch gekennzeichnet , daß die
Steuerung der Ringbreite unabhängig von der Bestrahlungszeit dadurch erfolgt, daß die Eindringtiefe des Lackentwicklers über den Grad der Luftevakuierung festgelegt
wird.

6. Verfahren nach den Ansprüchen 1 bis 5, d a d u r c h
g e k e n n z e i c h n e t , daß die Bohrungen des
Werkstückes mit einer Verengung hergestellt werden, so
daß sich der Lackring an dieser Stelle ausbildet.

7. Verfahren nach Anspruch 1 bis 4 und 6, d a d u r c h
g e k e n n z e i c h n e t , daß die Belichtung von
beiden Seiten unterschiedlich erfolgt, wenn die Lackstöpsel bezogen auf die Höhe der Bohrung nicht in der
Mitte liegen.

8. Verfahren nach Anspruch 1 bis 7, d a d u r c h
g e k e n n z e i c h n e t , daß vor der Abscheidung
einer oder mehrerer Metallschichten bzw. bei der Herstellung einer leitenden Ringzone vor dem Abätzen der
Grundmetallisierung die Werkstoffoberfläche ein- oder
beidseitig fotolithografisch mit einem Negativtrockenresist strukturiert wird, dessen Entwickler den Positivlackring in den Bohrungen nicht beschädigt.

9. Verfahren nach Anspruch 1, d a d u r c h g e -
k e n n z e i c h n e t , daß das Werkstück (1) ohne vorherige UV-Bestrahlung bei definiertem Unterdruck in ein
den Lack lösendes Entschichtungsmedium getaucht wird,
nach dem Druckausgleich für eine bestimmte Verweilzeit

- 10 -    VPA 80 P 7139 E

darin bleibt und anschließend durch Abspülen der Entschichtungsvorgang gestoppt wird, wobei anstelle des
Positiv-Fotolackes auch andere Lacke verwendet werden
können.

10. Verfahren nach Anspruch 9, d a d u r c h   g e -
k e n n z e i c h n e t ,   daß die verbleibende Lackringbreite durch die Größe des Unterdruckes vor dem
Tauchen des Werkstückes (1) in das Entschichtungsmedium
gesteuert wird.

Europäisches
Patentamt

**EUROPÄISCHER RECHERCHENBERICHT**

**0048380**
Nummer der Anmeldung

EP 81 10 7036

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| A | US - A - 4 160 310 (W.G. MANNS) | | H 01 J 9/14<br>C 23 F 1/02<br>C 25 D 5/02 |
| D/A | DE - A - 2 412 869 (SIEMENS) | | |

RECHERCHIERTE
SACHGEBIETE (Int. Cl.³)

C 23 F 1/04
C 23 F 1/02
H 01 J 9/26
H 01 J 9/14
C 23 C 3/00
C 23 D 5/02

KATEGORIE DER
GENANNTEN DOKUMENTE

X: von besonderer Bedeutung

A: technologischer Hintergrund

O: nichtschriftliche Offenbarung

P: Zwischenliteratur

T: der Erfindung zugrunde
liegende Theorien oder
Grundsätze

E: kollidierende Anmeldung

D: in der Anmeldung angeführtes
Dokument

L: aus andern Gründen
angeführtes Dokument

&: Mitglied der gleichen Patentfamilie, übereinstimmendes
Dokument

Der vorliegende Recherchenbericht wurde für alle Patentansprüche erstellt.

| Recherchenort | Abschlußdatum der Recherche | Prüfer |
|---|---|---|
| Den Haag | 09.12.1981 | TORFS |

EPA form 1503.1   06.78